# EUROPÄISCHE PATENTANMELDUNG

(11) **EP 3 131 379 A1**
(43) Veröffentlichungstag der Anmeldung: **15.02.2017**
(21) Anmeldenummer: 16184140.8
(22) Anmeldetag: 15.08.2016
(51) Int. Cl.: H05K 7/20, H05K 5/02, F25D 21/14

(54) **SPRITZSCHUTZ FÜR EINEN WÄRMETAUSCHER IN EINEM SCHRANK FÜR ELEKTRONISCHE KOMPONENTEN**

(30) Priorität: 14.08.2015 DE 102015215535
(71) Anmelder: Schäfer Werke GmbH, 57290 Neunkirchen (DE)
(72) Erfinder: TREPTE, Wolfgang, 01665 Diera-Zehren (DE); WERMKE, Thomas, 41844 Wegberg (DE)
(74) Vertreter: Grosse, Wolf-Dietrich Rüdiger

(57) **Zusammenfassung**

Kühleinrichtung (30) mit einem Wärmetauscher (33) und einem Spritzschutz (50), der wenigstens eine luftdurchlässige Abschirmung (52) aufweist, wobei die Abschirmung (52) aufgebaut und relativ zum Wärmetauscher (33) angeordnet ist, um Spritzwasser vom Wärmetauscher (33) abzufangen. Vorrichtung (1) mit einem Gehäuse (10), einer oder mehreren darin aufgenommenen elektronischen Komponenten (20) und einer solchen Kühleinrichtung (30), wobei der Spritzschutz (50) zwischen dem Wärmetauscher (33) und den elektronischen Komponenten (20) angeordnet ist.

## Beschreibung

### Technisches Gebiet

Die Erfindung betrifft eine Kühleinrichtung mit einem Wärmetauscher, sowie eine Vorrichtung mit einer oder mehreren elektronischen Komponenten und einer solchen Kühleinrichtung.

### Hintergrund der Erfindung

Elektronische Komponenten für die Datenverarbeitung erfordern eine Kühlung, die mit steigender Rechenleistung für immer höhere Wärmelasten ausgelegt sein muss. Wenn die reine Luftkühlung mittels Konvektion der Umgebungsluft an ihre Grenzen stößt, besteht eine Möglichkeit zur Steigerung der Kühlleistung darin, eine Luft-Kältemittel-Kühlung anzuwenden. Eine solche Kühlung wird in Schränken für IT-Komponenten, beispielsweise Serverschränken oder Schaltschränken, eingesetzt.

Die DE 10 2012 112 507 B3 beschreibt eine derartige Vorrichtung mit einer Kühlung, die ein umlaufendes Kältemittel verwendet. Es ist ein Schaltschrank beschrieben, der ein Gehäuse und einen daran schwenkbar angebrachten Wärmetauscher, der von einem Kältemittel durchströmt wird, hat. Ein weiteres elektronisches Gerät mit Luft-Kältemittel-Kühlung geht aus der DE 41 25 528 C2 hervor.

Indem das Kältemittel über ein Rohrsystem in den aufgeheizten IT-Schrank eingebracht wird, kann es vorkommen, dass sich Kondenswasser an den Komponenten der Kühleinrichtung, insbesondere den Komponenten am Kaltwasservorlauf, bildet. Auch außen am Wärmetauscher kann sich Kondenswasser bilden oder dorthin gelangen. Das Kondenswasser kann sich unkontrolliert verteilen, beispielsweise als Folge von Schwingungen oder Stößen wegspritzen, und auf diese Weise zu Schäden an den elektronischen Komponenten führen. Gleichzeitig erfordert ein ausreichender Sicherheitsabstand zwischen den elektronischen Komponenten und jenen des Kühlsystems Bauraum, der den elektronischen Komponenten verloren geht.

### Darstellung der Erfindung

Eine Aufgabe der Erfindung besteht darin, eine Kühleinrichtung mit einem Wärmetauscher bereitzustellen, die bei ausgezeichneter Kühlleistung und Raumausnutzung eine verbesserte Betriebssicherheit gewährleistet, insbesondere bei der Kühlung von elektronischen Komponenten in IT-Schränken. Eine weitere Aufgabe der Erfindung besteht darin, eine Vorrichtung mit einer oder mehreren elektronischen Komponenten und einer solchen Kühleinrichtung bereitzustellen.

Gelöst wird die Aufgabe mit einer Kühleinrichtung mit den Merkmalen des Anspruchs 1. Die Aufgabe wird ferner mit einer Vorrichtung mit den Merkmalen des Anspruchs 12 gelöst. Vorteilhafte Weiterbildungen folgen aus den Unteransprüchen, der folgenden Darstellung der Erfindung sowie der Beschreibung bevorzugter Ausführungsbeispiele.

Die Kühleinrichtung hat einen Wärmetauscher und einen Spritzschutz, der wenigstens eine luftdurchlässige Abschirmung, beispielsweise aus einem porösen Kunststoff, aufweist. Die Abschirmung dient dazu, Spritzwasser, das vom Wärmetauscher und/oder anderen Komponenten der Kühleinrichtung kommt, abzufangen und so zu verhindern, dass das Spritzwasser unkontrolliert benachbarte elektronische Komponenten einer etwaigen elektronischen Einrichtung erreicht. Der Luftaustausch vom und zum Wärmetauscher soll dabei nicht oder nur wenig beeinträchtigt sein.

Der Spritzschutz schirmt auf diese Weise den Wärmetauscher ab, er befindet sich zwischen dem Wärmetauscher und etwaigen elektronischen Komponenten. Damit werden die elektronischen Komponenten - oder allgemein die Umgebung des Wärmetauschers - vor Spritzwasser geschützt, was zu einer hohen Betriebssicherheit bei ausgezeichneter Raumausnutzung und Kühlleistung führt.

Die Abschirmung ist vorzugsweise flächig ausgebildet ist. Eine für den Schutz elektronischer Komponenten vor Spritzweise geeignete Dicke der Abschirmung liegt im Bereich von 0,5 bis 4 cm, besonders bevorzugt im Bereich von 1 bis 2 cm. Als Dicke wird hierbei die Abmessung senkrecht zur flächigen oder im Wesentlichen ebenen Erstreckung der Abschirmung verstanden.

Vorzugsweise ist der Wärmetauscher vollständig oder teilweise plattenförmig. Hierbei können eine oder mehrere Platten vorgesehen sein, zwischen denen die zu kühlende Luft zirkulieren kann. Vorzugsweise ist die Abschirmung oder sind die Abschirmungen parallel zum Wärmetauscher angeordnet, wodurch eine optimale Spritzwasser-Abschirmung erzielt wird, ohne dass sich die Abmessungen des Wärmetauschers durch den Spritzschutz wesentlich erhöhen. In besonderen Fällen kann es günstig sein, den Spritzschutz schräg zum Wärmetauscher, in einem bestimmten Winkel dazu anzuordnen. Der Wärmetauscher ist vorzugsweise aus Kupfer und/oder Aluminium gefertigt, weist vorzugsweise Lamellen auf und ist vorzugweise einfach ausbaubar, für Wartungsarbeiten oder eine eventuelle Reparatur.

Vorzugsweise weist der Spritzschutz einen Rahmen auf, in den die eine oder die mehreren Abschirmungen eingespannt sind, wodurch die Handhabung und die Montage der Abschirmung vereinfacht werden. Gemäß einer besonders bevorzugten Ausführungsform ist der Rahmen lösbar mit dem Wärmetauscher verbindbar. Damit vereinfacht sich die Wartung der Kühleinrichtung, insbesondere der Austausch der Abschirmung. Zu diesem Zweck weist der Wärmetauscher vorzugsweise ein oder mehrere Schienen auf, etwa im U-Profil geschnitten, in die der Rahmen eingeschoben werden kann.

Der Rahmen und/oder die Schienen sind vorzugsweise zum Teil, besonders bevorzugt im unteren Bereich, gelocht, damit das anfallende Wasser abgeschieden werden kann.

Die Abschirmung selbst kann auf verschiede Weise hergestellt sein, etwa als ein Lamellengitter und/oder Filter, vorzugsweise mittels eines porösen Materials. Eine Lage aus porösem Kunststoff kann ebenso zur Anwendung kommen, wie ein Lamellengitter, eine Filtermatte, geschäumter Werkstoff, Gewirk, etwa Gewebe oder Vlies usw.. Geeignete Materialien sind Kunststoff, Glasfaser, Metalle, wie etwa Stahl oder Aluminium. Die Abschirmung kann auch durch ein speziell geformtes Blech realisiert sein, etwa ein Kiemenblech oder Blech, welches durch seine Form geeignet ist, Spritzwasser abzuleiten ohne auf die elektronischen Komponenten spritzen zu können. Besonders bevorzugt kommt geschäumter Werkstoff zum Einsatz, der leicht, luftdurchlässig und kostengünstig ist.

Die Kühleinrichtung ist vorzugsweise eine Luft-Wasser-Kühlung, d.h. der Wärmetauscher und etwaige Rohre und andere Komponenten der Kühleinrichtung werden mit Wasser als Kältemittel durchströmt. Mit der Bezeichnung "Luft-Wasser-Kühlung" ist jedwede Kühlung umfasst, deren Kältemittel Wasser als Hauptbestandteil hat. Bevorzugt kommt hier ein Wasser/Glykol-Gemisch zum Einsatz, etwa mit einem Glykolanteil von 35%. Damit wird eine effektive und kostengünstige Kühlung, die ohne Spezialkältemittel auskommt, bereitgestellt.

Die Kühleinrichtung kommt besonders bevorzugt in einer elektronischen Einrichtung zur Anwendung. Die Vorrichtung weist in diesem Fall ein Gehäuse, eine oder mehrere darin aufgenommene elektronische Komponenten und eine Kühleinrichtung, wie sie oben beschrieben ist, auf, wobei der Spritzschutz zwischen dem Wärmetauscher und den elektronischen Komponenten angeordnet ist. Besonders bevorzugt handelt es sich bei der Vorrichtung um einen IT-Schrank, d.h. einen Schrank für elektronische Komponenten zur Datenverarbeitung, wie etwa Prozessoren, Speichereinrichtungen, Platinen, Akkus usw.. Die Kühleinrichtung dient zum Abführen der von den elektronischen Komponenten erzeugten Wärme aus dem Gehäuse. Dazu weist sie eine Zuleitung zum Einbringen eines Kältemittels, d.h. eines geeigneten Fluids, in das Gehäuse und eine Ableitung zum Abführen des Kältemittels aus dem Gehäuse auf. Die Zuleitung und/oder Ableitung können teilweise oder vollständig als Rohr und/oder Schlauch ausgeführt sein. Vorzugsweise sind die Zuleitung und/oder die Ableitung teilweise oder vollständig als Stahlrohr, Kupferrohr oder Aluminiumrohr gefertigt. Das Gehäuse selbst kann aus Metall, Kunststoff, Glas und/oder mittels anderer Materialien gefertigt sein, es kann zur äußeren Umgebung hermetisch abgeschlossen oder auch teilweise offen oder zu öffnen sein. Vorzugsweise weist das Gehäuse einen Stahlrahmen auf. Es können eine oder mehrere Türen vorgesehen sein. Unterhalb des Wärmetauschers kann eine Kondensatwanne, etwa aus Edelstahl, vorgesehen sein, um Kondenswasser aufzufangen. Ferner kann das Gehäuse einen Doppelboden aufweisen und/oder es können ein oder mehrere Ventilatoren vorgesehen sein, um die Luftzirkulation im Inneren des Gehäuses zu optimieren.

Die Zuleitung tritt an einer Leitungsdurchführung, die eine Öffnung in dem Gehäuse ist, in das Gehäuse ein, die Ableitung tritt vorzugsweise an derselben Leitungsdurchführung aus dem Gehäuse aus. Im Bereich der Leitungsdurchführung ist die Zuleitung vorzugsweise in der Ableitung oder die Ableitung vorzugsweise in der Zuleitung vorgesehen. In anderen Worten: im Bereich der Leitungsdurchführung werden die beiden Leitungen vorzugsweise "Rohr-in-Rohr" geführt. Der Bereich der Leitungsdurchführung umfasst zumindest die Gehäusedicke an dieser Stelle, d.h. dem Abschnitt, an dem die Leitungen durch die Gehäusewand geführt werden, vorzugsweise sind aber auch Abschnitte innerhalb und außerhalb des Gehäuses, unmittelbar im Anschluss an die Leitungsdurchführung umfasst. So ist die Bezeichnung "Bereich der Leitungsdurchführung" zu verstehen.

Indem im Bereich der Leitungsdurchführung die Zuleitung innerhalb der Ableitung oder die Ableitung innerhalb der Zuleitung vorgesehen ist, wird Bauraum eingespart, der etwa den elektronischen Komponenten zugutekommt. Darüber hinaus isoliert die äußere Leitung die innere Leitung, wodurch die Raumersparnis und die Isolation auf synergetische Weise miteinander kombiniert werden. Auf eine zusätzliche Isolation kann gegebenenfalls verzichtet werden. Insbesondere können die beiden Leitungen dünnwandig ausgeführt werden. Eine weitere technische Wirkung der hier dargestellten Rohr-in-Rohr-Lösung besteht darin, dass die Bildung von Kondenswasser reduziert, zumindest aber an eine Stelle verschoben wird, die tendenziell weiter im Inneren des Gehäuses liegt, als im Falle getrennter Zu- und Ableitung. Das ist insbesondere dann der Fall, wenn die Zuleitung in der Ableitung vorgesehen ist. Denn dann isoliert der warme Ablaufstrom den kalten Zulaufstrom, der beim Eintritt ins Gehäuse somit nicht unmittelbar auf die warme Atmosphäre im Inneren des Gehäuses trifft. Die Bildung von Kondenswasser wird verringert und weiter ins Innere verschoben, wo es etwa kontrolliert abgeführt werden kann und/oder in den Bereich des Spritzschutzes gelangt. In anderen Worten: der Rohr-in-Rohr-Abschnitt ermöglicht zusammen mit dem Spritzschutz eine Verbesserung der Kondenswasser-Kontrolle. Damit können das Gehäuse im Bereich der Leitungsdurchführung und die elektronischen Komponenten besser vor Kondenswasser geschützt werden, wodurch die Betriebssicherheit der Vorrichtung verbessert wird.

Die Zuleitung und/oder die Ableitung sind vorzugsweise luftdicht in der Leitungsdurchführung vorgesehen, so dass keine Luft zwischen dem Inneren und Äußeren des Gehäuses durch die Leitungsdurchführung ausgetauscht werden kann. In anderen Worten: an der Leitungsdurchführung liegt eine luftdichte Abschottung zum Gehäuseinneren vor. Damit wird verhindert, dass Feuchtigkeit und Luft an der Leitungsdurchführung Schäden, wie etwa Korrosion, anrichten. Mit der Rohr-in-Rohr-Lösung lässt sich die luftdichte Abschottung besonders einfach und dauerhaft realisieren, da das Gehäuse nur gegen den äußeren Querschnitt der beiden Leitungen abzudichten ist.

Die Temperaturdifferenz zwischen dem Kältemittel in der Zuleitung und dem Kältemittel in der Ableitung beträgt vorzugsweise maximal 8 K, liegt besonders bevorzugt zwischen 2 und 6 K. Konkret kann der Wärmetauscher so ausgelegt sein, dass im stationären Zustand 15°C auf der Kaltseite und 21°C auf der Warmseite anliegen. Eine effektive Kühlung bei kleinen Kältemittel-Temperaturdifferenzen erfordert einen großen Leitungsquerschnitt, der sich mittels der Rohr-in-Rohr-Lösung ausgezeichnet realisieren lässt. Im Falle eines kreisförmigen Querschnitts der Zuleitung und der Ableitung, die vorzugsweise konzentrisch zueinander vorgesehen sind, ist das Verhältnis aus Strömungsquerschnitt und Platzbedarf optimal.

Vorzugsweise ist der Abschnitt, in dem die Zuleitung in der Ableitung oder die Ableitung in der Zuleitung geführt wird, kürzer als diejenige Länge, mit der die Zuleitung und/oder Ableitung im Inneren des Gehäuses getrennt geführt werden. Damit soll zum Ausdruck gebracht werden, dass der Rohr-in-Rohr-Abschnitt vorzugsweise kurz ausgeführt ist, beispielsweise nur wenig länger ist als die Leitungsdurchführung.

Wenngleich die Erfindung besonders bevorzugt im Bereich von IT-Schränken zum Einsatz kommt, eignet sie sich auch für andere elektronische Einrichtungen, die ein Gehäuse und darin aufgenommene elektronische Komponenten, die eine effektive Kühlung erfordern, aufweisen oder andere Einrichtungen, die eine effektive Kühlung unter eingeschränkten Platzverhältnissen erfordern.

Weitere Vorteile und Merkmale der vorliegenden Erfindung sind aus der folgenden Beschreibung bevorzugter Ausführungsbeispiele ersichtlich. Die dort beschriebenen Merkmale können alleinstehend oder in Kombination mit einem oder mehreren der oben dargelegten Merkmale umgesetzt werden, insofern sich die Merkmale nicht widersprechen. Die folgende Beschreibung der bevorzugten Ausführungsbeispiele erfolgt dabei unter Bezugnahme auf die begleitenden Zeichnungen.

### Kurze Beschreibung der Figuren

Figur 1 zeigt schematisch einen Querschnitt durch einen IT-Schrank mit einem Gehäuse, darin aufgenommenen elektronischen Komponenten und einer Luft-Wasser-Kühlung.
Figur 2 zeigt den Wärmetauscher mit Spritzschutz der Figur 1 in einem Querschnitt.
Figur 3 zeigt den Wärmetauscher mit Spritzschutz der Figur 1 auf eine perspektivische, auseinandergezogene Weise.

### Detaillierte Beschreibung bevorzugter Ausführungsbeispiele

Im Folgenden werden bevorzugte Ausführungsbeispiele anhand der Figuren beschrieben. Dabei sind gleiche, ähnliche oder gleichwirkende Elemente in den Figuren mit identischen Bezugszeichen versehen, und auf eine wiederholende Beschreibung dieser Elemente wird teilweise verzichtet, um Redundanzen zu vermeiden.

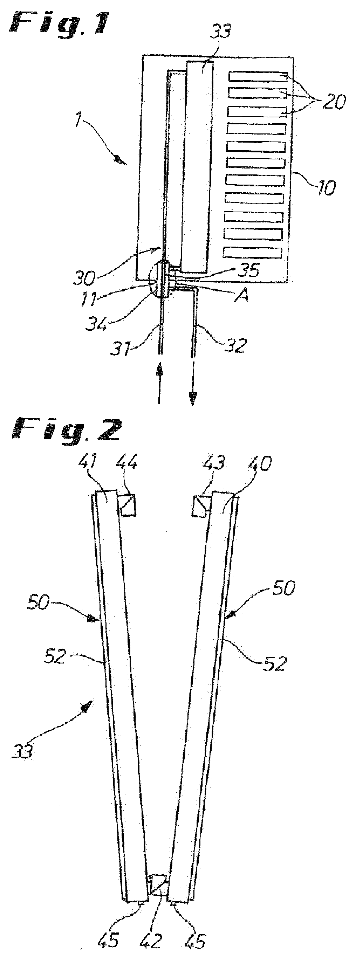

Die Figur 1 zeigt schematisch einen Querschnitt durch eine Vorrichtung 1, konkret einen IT-Schrank, mit einem Gehäuse 10, darin aufgenommenen elektronischen Komponenten 20 und einer Kühleinrichtung 30, die hier beispielhaft als Luft-Wasser-Kühlung ausgeführt ist. Die elektronischen Komponenten 20 umfassen etwa Prozessoren, Speichereinrichtungen, integrierte Schaltkreise, Akkumulatoren und andere Komponenten, die bei der elektronischen Datenverarbeitung Anwendung finden, Wärme abstrahlen und vor einer Überhitzung durch eine geeignete Kühlung geschützt werden müssen. Die Luft-Wasser-Kühlung 30 dient zum Abführen der von den elektronischen Komponenten 20 erzeugten Wärme aus dem Gehäuse 10. Dazu weist die Kühlung 30 eine Zuleitung 31 zum Einbringen von Kaltwasser in das Gehäuse 10 und eine Ableitung 32 zum Abführen von Warmwasser aus dem Gehäuse 10 auf. Die Zuleitung 31 und die Ableitung 32 sind als Rohre und/oder Schläuche, beispielsweise aus Kupfer, Stahl oder Aluminium, ausgeführt. Die Zuleitung 31 und die Ableitung 32 sind im Gehäuse 10 mit einem Wärmetauscher 33 verbunden, der zum Kühlen von Luft im Inneren des Gehäuses 10 vorgesehen ist. Das Gehäuse 10 selbst kann aus Metall, Kunststoff, Glas und/oder mittels anderer Materialien gefertigt sein, es kann zur äußeren Umgebung hermetisch abgeschlossen oder auch teilweise offen oder zu öffnen sein. Vorzugsweise weist das Gehäuse einen Stahlrahmen auf. Es können eine oder mehrere Türen vorgesehen sein. Unterhalb des Wärmetauschers kann eine Kondensatwanne, etwa aus Edelstahl, vorgesehen sein, um Kondenswasser aufzufangen.

Um die von den elektronischen Komponenten 30 erzeugte Wärme aus dem Gehäuse 10 zu transportieren, wird Kaltwasser (analog ein Kaltwassergemisch oder ein anderes Kältemittel) von außen über die Zuleitung 31 zugeführt und durchläuft den Wärmetauscher 33, wo wenigstens ein Teil der Wärme an das Kältemittel übertragen wird. Der Wärmetauscher 33 kann als Plattenwärmetauscher, Spiralwärmetauscher, aus Metall, Emaille, Kunststoff oder auf andere Weise vorgesehen sein, solange er eine Übertragung der Wärme im Inneren des Gehäuses 10 an das Kältemittel ermöglicht. Das auf diese Weise erwärmte Kältemittel wird über die Ableitung 32 aus dem Gehäuse 10 abtransportiert.

Sowohl die Zuleitung 31 als auch die Ableitung 32 treten an einer Leitungsdurchführung 11, die eine Öffnung in dem Gehäuse 10 ist, von außen in das Gehäuseinnere ein. Im Bereich A der Leitungsdurchführung ist die Zuleitung 31 im Inneren der Ableitung 32 vorgesehen. In anderen Worten: die Zuleitung 31 und die Ableitung 32 werden durch eine platzsparende Rohr-in-Rohr-Konstruktion miteinander verbunden, d.h. Kaltwasser und Warmwasser werden in einem gemeinsamen Rohr 34 durch die Gehäusewand geführt, wobei die beiden Fluide durch eine Trennwand 35 voneinander getrennt sind. Im Bereich A der Leitungsdurchführung werden die beiden Leitungen 31, 32 Rohr-in-Rohr geführt. Der Bereich A der Leitungsdurchführung umfasst zumindest die Gehäusedicke an dieser Stelle, d.h. dem Abschnitt, an dem die Leitungen durch die Gehäusewand geführt werden, vorzugsweise sind aber auch Abschnitte innerhalb und außerhalb des Gehäuses 10, unmittelbar im Anschluss an die Leitungsdurchführung 11 umfasst. Außerhalb des IT-Schranks 1 sind die Zuleitung 31 und die Ableitung 32 beispielsweise an eine nicht dargestellte Gebäudekühlanlage angeschlossen.

Das gemeinsame Rohr 34 ist luftdicht in der Leitungsdurchführung 11 vorgesehen, so dass keine Luft zwischen dem Inneren und Äußeren des Gehäuses 10 durch die Leitungsdurchführung 11 ausgetauscht werden kann.

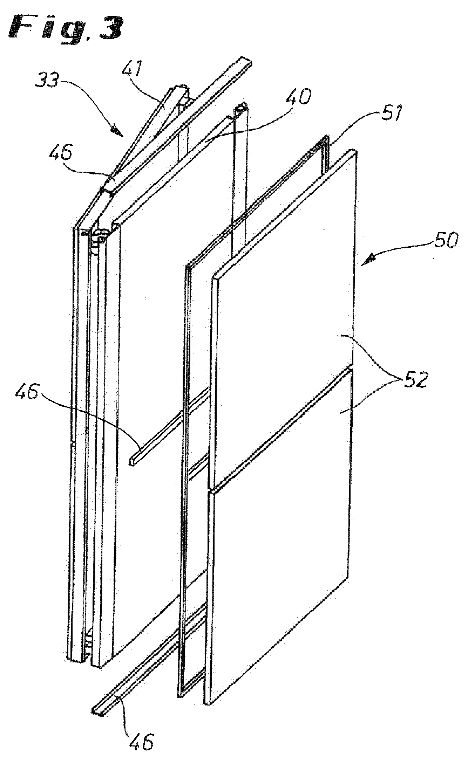

Die Figuren 2 und 3 zeigen den Wärmetauscher 33 im Querschnitt und auf eine auseinandergezogene, perspektivische Weise. Der Wärmetauscher ist hier beispielhaft zweiteilig ausgeführt, mit zwei plattenförmigen Wärmetauscherteilen 40 und 41. Eine Beschränkung auf eine solche zwei- oder mehrteilige Ausführung besteht nicht, sie ist aber nützlich, etwa um die Kühlleistung zu verbessern oder den Wärmetauscher 33 flexibel an unterschiedliche Kühlanforderungen anpassen zu können. Der Wärmetauscher 33 weist ferner Anschlüsse 42, 43 und 44 zur Anbindung an den Kältemittelkreislauf auf. Ferner sind Mittel zur Entlüftung 45 vorgesehen, zum Ablassen von Luft aus dem Kältemittelkreislauf.

Der Wärmetauscher 33 ist mit mehreren Schienen 46, hier als U-Profile aufgebaut, ausgestattet, wie es aus der Figur 3 hervorgeht. Im dort dargestellten Ausführungsbeispiel sind drei U-Profile 46 vorgesehen (jeweils für beide Wärmetauscherteile 40, 41), an zwei gegenüberliegenden Enden des Wärmetauschers 33, sowie mittig. Die U-Profile 46 dienen zur Aufnahme eines Spritzschutzes, der mit dem Bezugszeichen 50 bezeichnet ist.

Der Spritzschutz 50 weist einen Rahmen 51, beispielsweise aus Metall oder Kunststoff, und einen oder mehrere flächige Abschirmungen 52 auf, die in den Rahmen 51 eingespannt sind. Im Ausführungsbeispiel der Figur 3 sind zwei Filtermatten 52, eingespannt in den Rahmen 51, vorgesehen. Der Rahmen 51 lässt sich in die U-Profile 46 einschieben, wodurch der Spritzschutz 50 einfach montiert und ausgewechselt werden kann.

Damit der Spritzschutz 50 die Leistungsfähigkeit des Wärmetauschers 33 nicht beeinträchtigt, ist die Abschirmung 52 luftdurchlässig ausgeführt. Eine absolute Luft- und Wasserdichtigkeit ist auch nicht erforderlich, da er in erster Linie dafür ausgelegt ist, Spritzwasser, das vom Wärmetauscher 33 kommt, abzuhalten. Diese technische Wirkung wird auch dann erzielt, wenn der Spritzschutz 50 die Luftzirkulation nicht oder nur wenig beeinträchtigt. Die Abschirmung 52 kann auf verschiedene Weise aufgebaut sein: eine Lage aus porösem Kunststoff kann ebenso zur Anwendung kommen, wie ein Lamellengitter, eine Filtermatte, geschäumter Werkstoff, Gewirk, etwa Gewebe oder Vlies usw.. Geeignete Materialien sind Kunststoff, Glasfaser, Metalle, wie etwa Stahl oder Aluminium. Die Abschirmung 52 kann durch ein speziell geformtes Blech realisiert sein, etwa ein Kiemenblech oder Blech, welches durch seine Form geeignet ist, Spritzwasser abzuleiten ohne auf die elektronischen Komponenten 20 spritzen zu können. Die Dicke der Abschirmung 52 liegt vorzugsweise im Bereich von 1 bis 2 cm.

Der dargelegte Spritzschutz 50 schirmt die elektronischen Komponenten 20 ab, er befindet sich zwischen dem Wärmetauscher 33 und den elektronischen Komponenten 20. Damit werden die elektronischen Komponenten 20 vor Spritzwasser vom Wärmetauscher 33 geschützt, was zu einer hohen Betriebssicherheit bei ausgezeichneter Raumausnutzung und Kühlleistung führt. Der Rohr-in-Rohr-Abschnitt A ermöglicht ferner zusammen mit dem Spritzschutz 50 eine Verbesserung der Kondenswasser-Kontrolle.

Die Funktionsweise des Spritzschutzes 50 ist wie folgt: Die warme Abluft der elektronischen Komponenten 20, etwa angesaugt von Ventilatoren, durchströmt den Spritzschutz 50, also beispielsweise ein Labyrinth von Fasern oder aus Metall geformte Umlenkungen, bevor es zum Wärmetauscher 33 gelangt. Hierbei wird die Luft umgelenkt. Durch diese Umlenkungen kann Spritzwasser, welches zum Beispiel bei einer Leckage des Wärmtauschers entsteht, nicht zu den elektronischen Komponenten 20 gelangen, da Wasser Träger als Luft ist und den Umlenkungen nicht folgen kann. Das Wasser wird vorzugsweise in einer darunter liegenden Wannen gesammelt und kann abgeleitet werden. Das anfallende Spritzwasser kann durch den Druck auch fein zerstäubt sein. Durch einen etwaigen Vlies als Abschirmung 52, der eine große Kontaktfläche aufweist, werden die Aerosole zu Tropfen zusammengefasst und können sicher durch die Schwerkraft abgeleitet werden.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezugszeichenliste

- 1: IT-Schrank
- 10: Gehäuse
- 11: Leitungsdurchführung
- 12: Doppelboden
- 20: elektronische Komponenten
- 30: Luft-Wasser-Kühlung
- 31: Zuleitung
- 32: Ableitung
- 33: Wärmetauscher
- 34: gemeinsames Rohr
- 35: Trennwand
- 40,41: Wärmetauscherteile
- 42, 43, 44: Anschlüsse
- 45: Entlüftung
- 46: Schienen
- 50: Spritzschutz
- 51: Rahmen
- 52: Abschirmung
- A: Bereich der Leitungsdurchführung

## Patentansprüche

1. Kühleinrichtung (30) mit einem Wärmetauscher (33) und einem Spritzschutz (50), der wenigstens eine luftdurchlässige Abschirmung (52) aufweist, wobei die Abschirmung (52) aufgebaut und relativ zum Wärmetauscher (33) angeordnet ist, um Spritzwasser vom Wärmetauscher (33) abzufangen.

2. Kühleinrichtung (30) nach Anspruch 1, **dadurch gekennzeichnet, dass** die Abschirmung (52) flächig ausgebildet ist, vorzugsweise mit einer Dicke im Bereich von 0,5 bis 4 cm, besonders bevorzugt im Bereich von 1 bis 2 cm.

3. Kühleinrichtung (30) nach Anspruch 1 oder 2, **dadurch gekennzeichnet, dass** der Wärmetauscher (33) plattenförmig ist, mit einem, zwei oder mehr Wärmetauscherteilen (40, 41), zwischen denen Luft zirkulieren kann.

4. Kühleinrichtung (30) nach Anspruch 2 und 3, **dadurch gekennzeichnet, dass** die Abschirmung (52) parallel oder in einem bestimmten Winkel zum Wärmetauscher (33) angeordnet ist.

5. Kühleinrichtung (30) nach einem der vorhergehenden Ansprüche, **dadurch gekennzeichnet, dass** der Spritzschutz (50) einen Rahmen (51) aufweist, in den die eine oder die mehreren Abschirmungen (52) eingespannt sind.

6. Kühleinrichtung (30) nach Anspruch 5, **dadurch gekennzeichnet, dass** der Rahmen (51) lösbar mit dem Wärmetauscher (33) verbindbar ist.

7. Kühleinrichtung (30) nach Anspruch 6, **dadurch gekennzeichnet, dass** der Wärmetauscher (33) ein oder mehrere Schienen (46) aufweist, vorzugsweise U-Profile, in die der Rahmen (51) einschiebbar ist.

8. Kühleinrichtung (30) nach einem der Ansprüche 5 bis 7, **dadurch gekennzeichnet, dass** der Rahmen teilweise, vorzugsweise im unteren Bereich, gelocht ist.

9. Kühleinrichtung (30) nach einem der vorhergehen Ansprüche, **dadurch gekennzeichnet, dass** die Abschirmung (52) ein Blech und/oder ein Lamellengitter und/oder ein Gewirk und/oder einen Filter, vorzugsweise aus einem porösen Material, aufweist.

10. Kühleinrichtung (30) nach Anspruch 9, **dadurch gekennzeichnet, dass** die Abschirmung (52) aus geschäumten Werkstoff gefertigt ist.

11. Kühleinrichtung (30) nach einem der vorhergehenden Ansprüche, **dadurch gekennzeichnet, dass** der Wärmetauscher (33) mit einem Kältemittel, das Wasser als Hauptkomponente hat, vorzugsweise einem Wasser/Glykol-Gemisch, durchströmt wird.

12. Vorrichtung (1) mit einem Gehäuse (10), einer oder mehreren darin aufgenommenen elektronischen Komponenten (20) und einer Kühleinrichtung (30) nach einem der vorhergehenden Ansprüche, wobei der Spritzschutz (50) zwischen dem Wärmetauscher (33) und den elektronischen Komponenten (20) angeordnet ist.

13. Vorrichtung (1) nach Anspruch 12, **dadurch gekennzeichnet, dass** die Kühleinrichtung (30) eine Zuleitung (31) zum Einbringen eines Kältemittels in das Gehäuse (10) und eine Ableitung (32) zum Abführen des Kältemittels aus dem Gehäuse (10) aufweist, wobei die Zuleitung (31) an einer Leitungsdurchführung (11) in das Gehäuse (10) eintritt, die Ableitung (32) an der Leitungsdurchführung (11) aus dem Gehäuse (10) austritt und im Bereich der Leitungsdurchführung (11) die Zuleitung (31) in der Ableitung (32) oder die Ableitung (32) in der Zuleitung (31) vorgesehen ist.

14. Vorrichtung (1) nach Anspruch 12 oder 13, **dadurch gekennzeichnet, dass** die Zuleitung (31) und/oder die Ableitung (32) luftdicht in der Leitungsdurchführung (11) vorgesehen sind, so dass keine Luft zwischen dem Inneren und Äußeren des Gehäuses (10) durch die Leitungsdurchführung (11) ausgetauscht werden kann.

15. Vorrichtung (1) nach einem der Ansprüche 12 bis 14, **dadurch gekennzeichnet, dass** die Temperaturdifferenz zwischen dem Kältemittel in der Zuleitung (31) und dem Kältemittel in der Ableitung (32) maximal 8 K beträgt, vorzugsweise zwischen 2 und 6 K liegt.
